# EUROPEAN PATENT APPLICATION

(11) **EP 1 408 511 A1**
(43) Date of publication of application: **14.04.2004**
(21) Application number: 03447246.4
(22) Date of filing: 07.10.2003
(51) Int. Cl.: G11C 16/04

(54) **Single bit nonvolatile memory cell and methods for programming and erasing thereof**

(30) Priority: 07.10.2002 US 416610 P
(71) Applicant: INTERUNIVERSITAIR MICROELEKTRONICA CENTRUM VZW, 3001 Leuven (BE); Infineon AG, 81541 München (DE)
(72) Inventor: Xue, Gang, 3001 Leuven (BE); Van Houdt, Jan, 3460 Bekkevoort (BE)
(74) Representative: Van Malderen, Joelle

(57) **Abstract**

The present invention is related to a single bit, non-conductive floating gate memory cell, is introduced which can operate at ultra low voltages. Substrate bias is used to promote the injection of carriers into the floating gate, resulting in lower voltages to program and erase the memory cell. The memory cell is arranged in an array of bit lines running perpendicular to the program line and word lines. Adjacent memory cells in each column share either a common source or a common drain node. The bit line connects the source nodes in each column, while the program line connects the drain node of memory cells at corresponding positions in each line. The reduced programming voltage allows the use of lower program inhibit voltages on the bit line.

## Description

### Field of the invention

The present invention generally relates to electrically programmable and erasable memory (EEPROM) devices, more particularly to single gate memory devices using a dielectric layer for locally storing and retaining a single bit of injected charge.

The present invention further particularly relates to methods for programming and erasing such memory devices at reduced voltages using hot-carrier injection.

### State of the art

Flash EEPROM memories comprise the largest class of electrically alterable, nonvolatile semiconductor memories. They represent the fastest growing segment of all semiconductor memories, offering high integration densities, fast read access, electrical write and erase and allow a permanent data storage. Flash EEPROM memories offer the ability of erasing all or selected groups of the memory cells. Charge is stored on a floating gate, which modulates the conductance of a MOS channel underneath it. This floating gate is electrically insulated from its surroundings by a high quality dielectric, such as SiO₂. A control gate, capacitively coupled to the floating gate, is used to modulate the electrical potential of the floating gate. The floating gate is formed from a conductive material such as polycrystalline silicon in which case injected charge will be distributed over the whole of the conductive floating gate.

Alternatively a non-conductive material, such as nitride, can be used to store charge on. Charge introduced into the non-conductive gate will, to a large extent, be confined to the place of introduction and as a result only a limited amount of charge is needed to program the memory cell. PCT application WO 99/07000 discloses a two-bit non-volatile EEPROM cell using a nitride layer sandwiched in between a top and a bottom oxide layer. This memory cell is programmed using conventional channel-hot-electron-injection to inject electrons into the nitride layer. Channel-hot-electron-injection requires the junction region to overlap the nitride layer as the injection of the hot carriers occurs at the position of the maximum electrical field, which corresponds to the metallurgical junction between the drain and the well. Hence a sharp and well-controlled doping profile must be realized too.

The symmetrical layout of the device allows, by appropriately selecting the voltages, electrons to be injected on either side of the non-conductive floating gate. Two bits of data can hence be stored, each bit on an opposite side of the floating gate. Erasing of the cell is done by removing the trapped electrons, through the top or the bottom electrode, using Fowler-Nordheim tunneling. The stored bits are read in "reverse direction": the bit at the drain side is read, i.e. the shift in threshold voltage at this point, is measured, by grounding the drain and biasing the source and the gate voltage such that saturation is reached in the channel region near the source. This saturation region will mask the influence of the charge, which is stored near the source junction. In the ideal case only the influence of the charge stored near the drain junction on the cell current is measured when reading the drain bit. The doping profile must thus not only be engineered to enable localized injection of carriers, but also to allow screening of the bit on the opposite side of the one being sensed.

If flash memory is to be integrated with high performance logic circuitry then the voltages required to program, read or write the cell must be compatible with the supply voltage of the logic circuitry on chip. Otherwise complex and area consuming charge pump circuits and high voltage circuits, which are e.g. used in the decoder circuitry, must be provided on chip to provide the internal or on-chip voltages needed to operate the flash memory. The scaling of the transistor dimensions towards 0.35 micrometer and below will however also scale down the available supply voltage from 5V towards 3.3V and below. Providing sufficient power to operate the memory cell becomes even more difficult when the supply voltage is scaled and the memory array density is increased, leaving less area for the column drivers. Furthermore the charge pump circuits, which generate the high memory operating voltages for programming and erasing from the low supply voltage, become less efficient and more area consuming as the supply voltage is decreased.

Using conventional channel-hot-electron-injection (CHE) requires a gate voltage of 8-9V or above. Such programming voltages are much higher than the supply voltage offered in submicron CMOS technology. Programming methods are developed to reduce the required programming voltages. S. Mahapatra, S. Shukuri and J. Bude et al disclose in "Chisel Flash EEPROM-Part1: Performance and scaling", IEEE Trans. Electron Devices, July 2002, pp.1296-1301 a low-voltage programming technique using substrate-enhanced-hot-electron injection, also often referred to as CHISEL, to scale the gate voltage of a stacked gate memory cell down to 5-6V. The proposed device still requires higher programming voltages to attract carrier towards the polysilicon floating gate, e.g. 8V at the control gate.

In European Application EP 1,096,572 another low-voltage programming technique is disclosed. The mechanism of drain-induced-secondary-impact-ionisation is used to inject hot electrons into the floating gate of a split-gate memory cell. Due to overlap of the floating gate over the drain junction, the drain voltage is capacitively coupled to the floating gate and assists in attracting the secondary electrons towards the floating gate.

Although methods exist to lower somewhat the programming voltage, reduction of the erase voltage is still burdensome. Using FN tunneling for erasing floating gate memory devices requires the use of large electrical fields, as the dielectric layers electrically insulating the floating gate cannot be scaled to such extent that the corresponding voltages are considerably lowered. Even when a negative voltage is applied to the gate, the voltages used during the step of erasing the memory cell are still above 6V due of the poor scalability of the top and bottom oxide layers through which the stored electrons must tunnel. Reliability concerns such as moving bits and stress induced leakage current will put a lower limit to these oxide layers.

### Aims of the invention

An aim of the present invention is to allow low-voltage operation on-chip of an embedded flash EEPROM single gate memory cell and arrays thereof.

An aim of the present invention is to disclose a low-voltage programming method for a single gate, single bit memory cell comprising a charge-storing dielectric.

An aim of the present invention is to disclose a low-voltage programming method for a single poly single bit memory cell comprising a charge-storing dielectric.

An aim of the present invention is to disclose a low-voltage erasing method for a single gate, single bit memory cell comprising a charge-storing dielectric.

It is an aim of the invention to present a single bit EEPROM device in which programming and erasing methods are at least as efficient as those used in the prior art, while, however, requiring only much lower voltages.

An aim of the present invention is to allow efficient use of chip-area, particularly when further downscaling the CMOS technology in which both the logic circuitry as well as the integrated EEPROM is manufactured.

An aim of the present invention is to allow further downscaling of flash single bit memory cells using a layer of a non-conductive material as floating gate.

Another aim of the present invention is to reduce the costs of integrating flash memory cells in a CMOS process. This is particularly important for so-called embedded memory applications where the process steps related to the manufacturing of the memory cells have to be reconciled with the available CMOS process for fabricating chips.

Another aim of the invention is to disclose a memory cell concept that can be used for embedded Flash technology for wireless System-On-a-Chip applications.

### Summary of the invention

In a first aspect of the invention a single bit nonvolatile memory cell capable of being integrated on a chip in a metal-dielectric-semiconductor technology. This memory cell (1) comprising a semiconductor substrate (2) including a source (3), a drain (4), a channel region (10) in-between said source (3) and said drain (4), a gate electrode (5) separated from said channel region by a dielectric stack (6), said dielectric stack comprising at least one charge storing dielectric layer (8).

In a first aspect of the invention, a method for programming the single bit, single gate nonvolatile memory cell of the first aspect is disclosed. Said memory cell (1) comprising a semiconductor substrate (2) including a source (3), a drain (4), a channel region (10) in-between said source (3) and said drain (4), a gate electrode (5) separated from said channel region by a dielectric stack (6), said dielectric stack comprising at least one charge storing dielectric layer (8). Said programming method comprising the steps of biasing said source (3) to ground, applying a first voltage of a first sign to said drain (4), applying a second voltage of a first sign to said gate (5), and applying a third voltage of an opposite sign to said semiconductor substrate (2), said first, said second and said third voltage cooperatively establishing programming of said cell using secondary-impact-ionization-carriers. The difference in absolute value of the first, second and third voltage being applied respectively to the drain, gate and bulk during programming is 1.5V or less, preferably 1V or less. The absolute value of the first, second and third voltage being applied respectively to the drain, gate and bulk during programming is about the same value. Preferably this absolute value is 5 V or less, more preferably this absolute value is 4.5V or less.

In a second aspect of the invention a method for erasing a single bit, single gate nonvolatile memory cell according to the first aspect is disclosed. Said memory cell (1) comprising a semiconductor substrate (2) including a source (3), a drain (4), a channel region 10 in-between said source (3) and said drain (4), a gate electrode (5) separated from said channel region by a dielectric stack (6), said dielectric stack comprising at least one charge storing dielectric layer (8). Said erasing method comprising the steps of biasing said source (3) to ground, applying a first voltage of a first sign to said drain (4), applying a second voltage of an opposite sign to said gate (5) and applying a third voltage of an opposite sign to said semiconductor substrate (2), said first, said second and said third voltage cooperatively establishing programming of said cell using band-to-band-tunneling-induced-hot-carrier injection. The difference in absolute value of the first, second and third voltage being applied respectively to the drain, gate and bulk during programming is of 1.5V or less, preferably 1V or less (Same remark as above). The absolute value of the first, second and third voltage being applied respectively to the drain, gate and bulk during programming is about the same value. Preferably this absolute value is 5 V or less, more preferably this absolute value is 4.5V or less.

In a third aspect of the invention an efficient array configuration for the memory device according to the first aspect is disclosed. The memory cells of the first aspect are organized in columns. Two adjacent memory cells in each column have either the drain (4) or the source (3) node in common The drain (4) nodes of two adjacent memory cells in each column are connected to form a program line PL, running perpendicular to the cell column. Preferably this program PL is formed in a first interconnect layer of metal connected via contacts or vias to the drain junction. The source nodes (3) of the memory cells in each column are connected to form a bit line, running parallel to the corresponding cell column. Preferably this bit line is formed in a second, higher, interconnect layer of metal connected via contacts or vias to the source junction. From each column the gate (5) of memory cells at identical horizontal positions in each column are connected by the word line WL, running perpendicular to the cell column. Preferably this word line is formed in the polycrystalline silicon used to form the gate electrode (4) of each memory cell. So word lines and program lines are arranged in parallel.

### Brief description of the drawings

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Figure 1 represents a schematic cross-sectional layout of a memory device according to the present invention

Figure 2 represents programming characteristics of a device according to the present invention illustrating the threshold voltage window, and more particularly the influence of the substrate bias.

Figure 3 represents a comparison of the bit-bit interference according the prior art (CHE) and the invention (SEHE).

Figure 4 represents erase characteristics of a device according to the present invention illustrating the threshold voltage window, and more particularly the influence of the substrate bias.

Figure 5 represents endurance characteristic of a memory device programmed and erased according to embodiments of the invention.

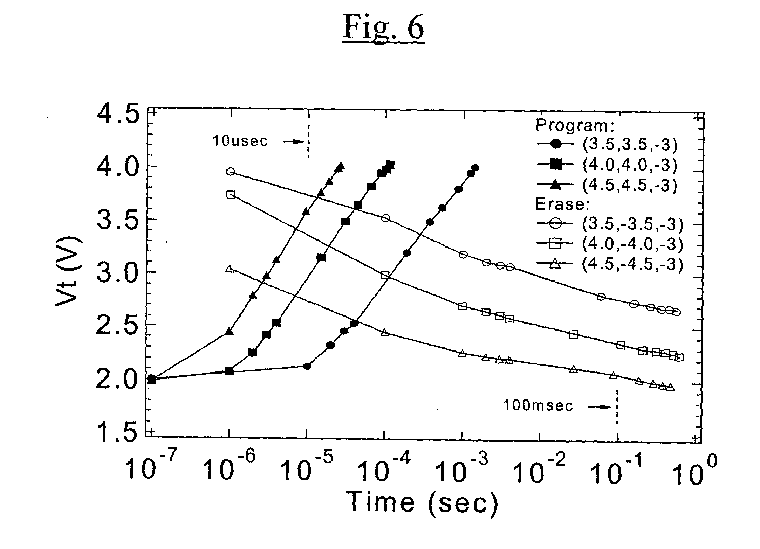

Figure 6 represents cell performances when programming and erasing a memory device according to embodiments of the invention.

Figure 7 represents a suitable memory array configuration for the memory device according to an embodiment of the invention.

Figure 8 represents a program inhibit behavior of the memory architecture according to embodiments of the invention.

### Detailed description of the invention

The invention is described in the sequel through a detailed description of several embodiments of the invention. It is obvious that other embodiments of the invention can be configured according to the knowledge of persons skilled in the art without departing from the true spirit of the invention.

With supply voltage is meant the voltage used to supply power to any logic circuit on chip, fabricated in the CMOS technology in which the non-volatile memory cells are incorporated. Any externally applied voltage other than the supply voltage defined above will be referred to herein simply as an "external voltage". With "internal voltage" is meant the voltage available on-chip, which is generated by charge pump circuits from the lower supply voltage.

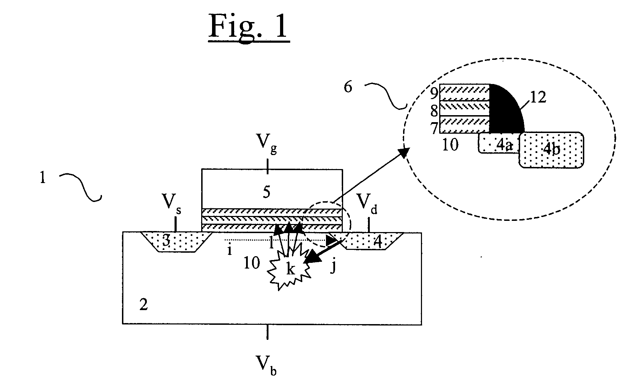

In a first aspect of the invention a single non-volatile memory cell is disclosed. Figure 1 shows a schematic cross-sectional layout of a single gate device (1) according to a first embodiment of this aspect. In a semiconductor substrate (2), e.g. a silicon wafer, source (3) and drain (4) highly doped junctions are formed self-aligned to a single gate, which comprises a conductive gate (5) formed on a stack (6) of dielectrics layers. Because the MOSFET structure available in the core CMOS technology is used, the junction regions (3) and (4) will essentially not overlap the gate region (5). As shown in the inset of figure (1) for the drain side a doped extension 4a (and potentially a lowly doped extension), underneath a spacer (12), can be present to form a conductive path between the highly doped junction (4b) and the channel region (10), as is common practice in submicron CMOS technology. The source (3) and drain (4) junctions are of a doping type opposite to the doping type of the substrate (1) or well. For the purpose of teaching the invention an n-channel device will be used wherein n-type junctions are thus formed in a p-type substrate or p-well. A person skilled in the art will acknowledge that the methods, cell structures and arrays disclosed in the present application could also apply to a p-channel device. With source and drain junction is meant the highly doped junction regions formed adjacent this single gate. Although the device structure is symmetrical, the term "drain" is used to identify the side of the device from which the bit is programmed.

The conductive gate (5) is used as gate electrode to bias the underlying FET structure. The underlying stack (6) of dielectric layers acts as the gate dielectric of this FET structure and can be a sandwich of a first (7), a second (8) and a third (9) dielectric layer. The first (7) and third (9) dielectric layers are electrically insulating the middle layer (8). This middle layer (8) is used as a charge trapping or charge-storing layer. The stack of dielectric layers must be capable of receiving charge carriers injected from the channel region (10) below. The injected charge carriers must be stored and retained within the non-conductive middle layer (8). The charge trapping layer (8) can be a nitride layer, an oxide layer with buried separated poly-silicon islands where the charge is stored within these conductive poly-silicon islands, a layer comprising separated silicon microcrystals, where the charge can be stored in these separated silicon microcrystals, a silicon-rich oxide, a high-k dielectric such as HfO₂, Al₂O₃ or ZrO₂. The stack (6) of dielectric layers (7, 8, 9) can be formed by depositing a first dielectric (7) on top of a major surface of the semiconductor substrate (2). This first dielectric (7) is typically silicon dioxide formed by thermal oxidation of the silicon substrate (1) or can be deposited by a variety of CVD (chemical vapour deposition) techniques, e.g. TEOS formed by Low Pressure CVD, oxides formed by Atomic Layer CVD. Typically the thickness of this first dielectric is between 3 and 20 nm, preferably between 3 and 10nm. The second dielectric (8) is formed on top of the first dielectric (7), which electrically insulates this second dielectric (8) from the channel region ('10) underneath. Typically the second dielectric (8) is a silicon nitride, having a thickness between 2 and 20 nm, preferably between 5 and 12nm. On top of the second dielectric (8) a third dielectric layer (9) is formed, e.g. by CVD, which electrically insulates the second dielectric (9) from the gate (5). Typically this third dielectric (9) is a silicon oxide having a thickness between 3 and 20 nm, preferably between 3 and 10nm. In the thus formed ONO (oxide-nitride-oxide) stack (6) the nitride layer (8) provides the charge retention mechanism for programming the memory cell. On top of the third dielectric layer (9) a conductive gate (5) is formed. Typically polycrystalline silicon having a thickness ranging from 100 to 400 nanometer (nm) is used as gate material, in which case the device could be labeled as a single poly device. The conductive gate (5) will be of the same doping type as the source (3) and drain (4) junctions.

An advantage of the devices according the first aspect of the invention is that these devices can be manufactured using the MOSFET structure already available in the core CMOS technology, thereby requiring only one additional masking step. The device shown in figure 1 comprises the MOSFET elements of a gate (5), source (3) and drain (4) terminals and a dielectric layer (6) separating the gate (5) from the channel region (10) in-between this source (3) and drain (4) region. This additional masking step is needed to remove the uniformly deposited non-conductive charge-storing layer outside the region on the chip allocated to the memory array. In a preferred embodiment of the invention, the formation of the dielectric stack (6) is first formed uniform over the wafer and, by using a masking step, then removed outside the memory region. The gate dielectric, e.g. silicon oxide, of the non-memory or logic devices is formed uniformly over the wafer. After the formation of this logic gate dielectric, the gate electrode layer, e.g. a polycrystalline layer, is deposited over the wafer. This gate electrode layer is patterned to form the gate of the logic devices as well as the gate of the memory cells. All other steps available in the core CMOS technology, and as such known by a person skilled in the art, can be further applied to complete the MOSFET structures of both the logic and of the memory part of the chip.

Another advantage of the devices according to embodiments of the invention is that the proposed devices don't require elaborate junction engineering to ensure, inter alia, localised hot carrier injection.

The results presented in this application are obtained in 0.18um CMOS technology: the thickness of the ONO stack (6) of this SONOS (semiconductor-ONO-semiconductor) device is 5.5nm for the bottom oxide (7), 8.5nm for the nitride layer (8), 5.5nm for the top oxide layer (9). The n-type source (3) and drain (4) junctions are 0.12um deep and formed in a retrograde well having a doping of 3e17 cm². The cell size is 0.54 um² with a width over length ratio W/L of 0.25um/0.18um. However the methods as disclosed in this patent application can be applied to any non-volatile memory technology embedded in a CMOS technology. A person skilled in the art will however appreciate the advantages of the embodiments presented when scaling down the CMOS technology, in which the non-volatile memory is integrated with logic circuitry, to submicron dimensions.

In a second aspect of the invention a method is disclosed for programming a single gate non-volatile memory cell comprising a charge-storing dielectric layer, as disclosed in the first aspect of the invention. The memory cell is programmed from the drain side, by applying a first voltage of a first sign to the drain junction (4), a second voltage of a first sign to the gate (5), a third voltage of an opposite sign to the substrate (2) and biasing the source junction (3) to ground. Primary carriers, electrons in this teaching, will then migrate from the source (3) through the channel 10 to the drain (4) (arrow i) and gain energy from the drain-source voltage thereby creating electron-hole pairs by a first impact ionisation mechanism in or near the drain. One type of the thus generated carriers, "first-impact carriers" which are holes in this teaching, will travel from the point of impact into the bulk (2) of the device (arrow j) and gain energy from the drain-bulk voltage thereby creating, in the bulk electron-hole pairs by a second impact ionisation event. Because the position where this second impact ionisation occurs depends on a number of parameters such as, inter-alia, the energy of the first-impact carriers, their diffusion life-time, the bulk doping, the doping profile and depth of the drain junction, one can not speak of an impact position but rather of an impact region as indicated by the cloud k. One type of the thus generated carriers, "second-impact carriers" which are electrons in this teaching, will be attracted towards the gate (5) by the gate voltage and will be injected near the drain side (4) into the dielectric stack (6) comprising the charge-storing dielectric (8) (arrows 1). Because of the statistical nature of this process, as indicated by the cloud k, the second-impact carriers will not be injected into the dielectric stack (6) at one single position along the channel as would be the case for classical hot-electron-injection, but at a statistically distributed set of points. The programming mechanism exploited in this embodiment charges the charge storing layer by a less-localized injection of hot carriers, generated by a secondary impact ionisation mechanism, taking place in the bulk of the device. Instead of having the majority of the injected charges stored at substantially the same location in the dielectric stack (6), the injected charge is distributed over a region within this dielectric stack, this region being determined by the statistics of the overall carrier generation process.

Because the primary electrons will only need to gain enough energy to generate the first-impact carriers; a lower voltage difference between the source (3) and the drain (4) can be applied. Because the first-impact carriers must gain enough energy to generate second-impact carriers; a moderate voltage difference between the drain (4) and the substrate (2) can be applied. The gate (5) to substrate (2)-voltage must be large enough for the second-impact carriers to gain sufficient energy to cross the substrate-dielectric energy barrier. If oxide is used as a first dielectric (7) then this energy barrier is 3.2eV for electrons and 4.8eV for holes. For the device proposed by J. Bude, as discussed in the prior art section, the injected charge is stored on a conductive floating gate and not on a non-conductive charge-storing dielectric (6) as disclosed in the embodiments of the invention. In order to attract the generated carriers towards this floating gate Bude must apply a very high voltage to the gate electrode (5) as only a part of this gate voltage will be available at the floating gate due to the capacitive divider which is created between the substrate (2), the floating gate and the gate electrode (5). Such capacitive divider is not present in the device disclosed in the embodiments, allowing a lower gate (5) to substrate (2)-voltage.

The difference in absolute value of the first and second being applied respectively to the drain, gate and bulk during programming is 1.5V or less, preferably 1V or less. The difference in absolute value of the first, second and third voltage being applied respectively to the drain, gate and bulk during programming is 1.5V or less, preferably 1V or less. The absolute value of the first, second and third voltage being applied respectively to the drain, gate and bulk during programming is about the same. Preferably this absolute value is 5 V or less, more preferably this absolute value is 4.5V or less.

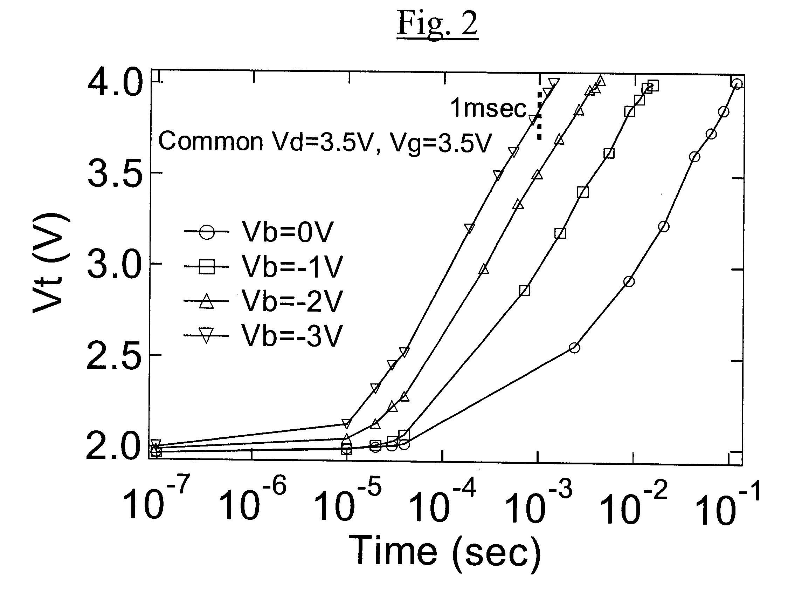

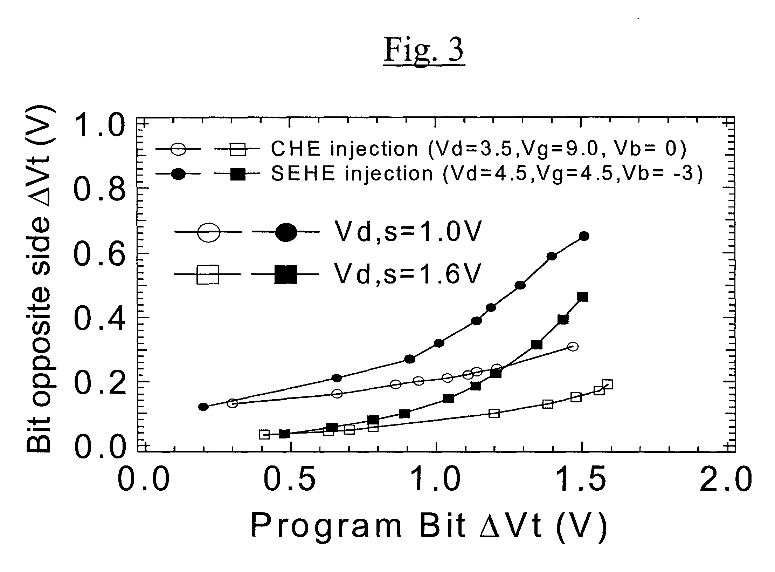

In a preferred embodiment the drain is biased to 3.5V, the gate to 3.5V while the substrate is biased to -3V. Figure 2 shows the shift (V) in threshold voltage Vt of the programmed memory cell as function of time (sec) for four different values of the bulk bias (Vb = 0,-1, -2, -3V) for a given drain Vd and gate Vg voltage of 3.5V, while the source voltage Vs is put to zero. In this embodiment the first and second voltage have a positive sign, while the third voltage has a negative sign. A more negative bulk bias will lead to an improved programming efficiency, as the threshold voltage shift after a given programming time, e.g. 1 msec, becomes larger with increasing bulk bias. The substrate bias thus contributes to the generation and/or acceleration of hot electrons near the drain junction, therefore the programming mechanism of the present invention is labelled as substrate-enhanced-hot-electron-injection (SEHE). One feature of this programming mechanism is that, contrary to the conventional channel-hot-electron (CHE) mechanism, carriers are not injected into the floating gate (6) at a well-defined position. The injection of the carriers according to the present invention is a non-local injection phenomenon, showing a much more scattered injection behaviour. Figure 3 illustrates the difference between the present invention and channel-hot-electron with respect to the spread of the injection position when programming the device of figure 1. When programming the drain side, being the "program bit", according to the present invention, the change in threshold voltage ΔVt (V) at the source side, being the "bit at the opposite side", of the transistor is monitored. The two bits are read, i.e. the shift in threshold voltage is measured at two values of the read voltage Vds between source and drain: 1V and 1.6V. Using conventional channel-hot-electron (CHE), as is the case for the dual bit memory cell of PCT application WO 99/07000, only results in a small shift of the threshold voltage at the source side. This highly localized hot electron injection mechanism is exploited in PCT application WO 99/07000 to develop a dual bit device, wherein two bits of data are stored at the two extreme positions of the floating gate (6). Using substrate-enhanced-hot-electron-injection a larger shift in threshold voltage at the source side is observed for a given shift in threshold voltage at the drain side, indicating interference between these positions in the floating gate. Even when a bit line read voltage of Vds = 1.6V is used at the source side to read the bit at the drain side, the increased threshold voltage at source side cannot be masked. This effect is exploited in this embodiment by only storing a single bit of data into the floating gate. As a result the disclosed efficient, low voltage, programming mechanism can be used for this device. The single bit device of this embodiment has an asymmetric charge storage mechanism: charge is stored from the drain side onwards, but is not located at the drain side only. As the memory cell is programmed from the drain side and read from the source side, a lower bit line read voltage, e.g. 1V, compared to the read voltage, e.g. 1.5V of the two-bit memory device of PCT application WO 99/07000 can be used. The higher read-out voltage used in the prior art is required to extend the depletion region of the junction to mask the neighboring bit that is not being read out. However this higher read-out voltage might result in a so-called soft write error: some carriers of the read-out current might gain enough energy to be injected into this masked bit and hence add unwanted charge to this bit..

When further scaling down the channel length no latent bit-bit interference is to be expected as only one bit is programmed.. Scaling the channel length would bring the two bits of the prior art device together with a higher probability for interference between these two bits. Programming only 1 bit as disclosed in this application promotes the scalability of the proposed device, but also the lower operating voltages allow shrinking of device dimensions. The lower the voltages the closer the source and drain junctions can be brought together as breakdown is less likely to occur even for short channel lengths.

In a third aspect of the invention a method is disclosed for erasing the single gate non-volatile memory cell (1) comprising a charge-storing dielectric layer as disclosed in the first aspect of the invention. The memory cell is erased from the drain side, by applying a first voltage of a first sign to the drain junction (4), a second voltage of an opposite sign to the program gate (4), a third voltage of an opposite sign to the substrate (1) and biasing the source junction (3) to ground. The erasing mechanism uses injection of hot carriers into the charge storing dielectric (8) near the drain side (4) of the memory cell (1). These carriers will be of an opposite type than the carriers used for programming, e.g. in this teaching electrons are injected during programming, while holes are injected during erasing. By applying a negative voltage to the gate (5), the drain (4) is put into deep depletion and "cold" holes can be generated by band-to-band tunnelling between the drain (4) and the channel region (10). These "cold" holes gain sufficient energy from the surface lateral electrical field to become hot and to cross the substrate-dielectric energy barrier. If oxide is used as a first dielectric (7) then this energy barrier is 3.2eV for electrons and 4.8eV for holes. The gate-drain voltage must be sufficient to form a deep depletion region at the drain side and allow band-to-band tunnelling of carriers used for erasing. The gate (5) to substrate (2)-voltage must be large enough for these carriers to gain sufficient energy to cross the substrate-dielectric energy barrier.

The difference in absolute value of the first, second and third voltage being applied respectively to the drain, gate and bulk during programming is 1.5V or less, preferably 1V or less. The absolute value of the first, second and third voltage being applied respectively to the drain, gate and bulk during programming is about the same value. Preferably this absolute value is 5 V or less, more preferably this absolute value is 4.5V or less.

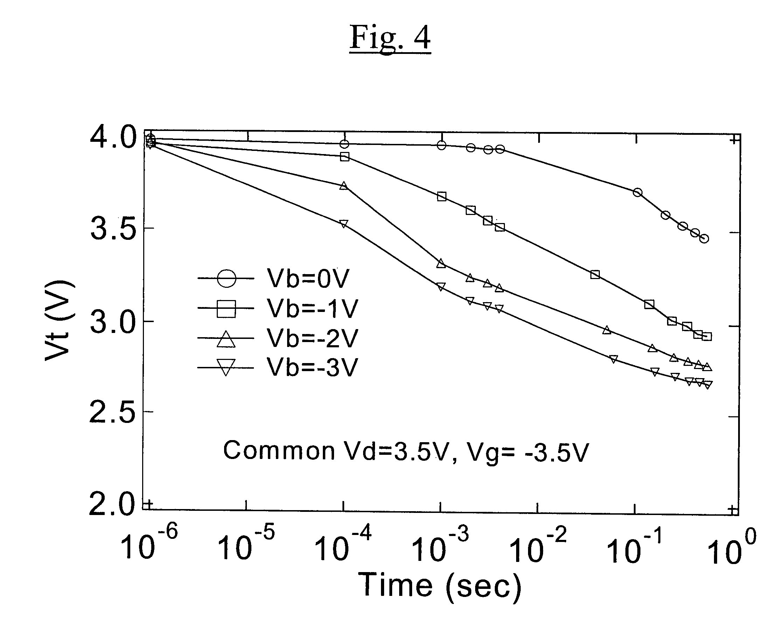

In a preferred embodiment the drain (4) is biased to 3.5V, the gate (5) to -3.5V while the substrate (2) is biased to -3V and the source (3) is put to 0V. Figure 4 shows the shift (V) in threshold voltage Vt of the erased memory cell as function of time (sec) for four different values of the bulk bias (Vb = 0, -1, -2, -3V) for a given drain voltage of 3.5V and gate voltage of -3.5V,while the source voltage Vs is put to zero. In this embodiment the first voltage has a positive sign, while the second and third voltage have a negative sign. A more negative bulk bias will lead to an improved erase efficiency, as the threshold voltage shift after a given erase time becomes smaller with increasing bulk bias. The substrate bias thus contributes to the generation and/or acceleration of hot holes near the drain junction, therefore the erasing mechanism of the present invention is labelled as substrate-enhanced-band-to-band-tunneling-induced-hot-hole-injection (SEBBHH). By applying a negative bias the surface lateral field is enhanced. The "cold" holes generated by surface band to band tunnelling can gain energy from this enhanced lateral field, become "hot" and can be injected into the floating gate (6). Since the erase method is based on the injection of hot carriers, the erase efficiency is independent of the thickness of the bottom oxide. One advantage of the erasing method according to this embodiment is that the bottom oxide need not to be scaled to allow erasing, but can be kept thick in order to guarantee good retention capability.

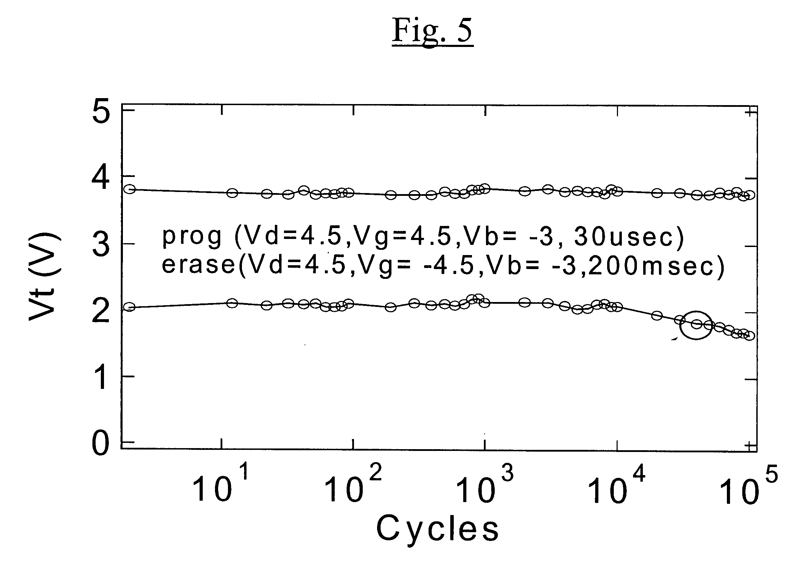

Figure 5 shows the endurance characteristics of the cell programmed and read according to embodiments of the invention. More than 100 000 cycles can be obtained.

An overview of the voltage window for programming and erasing the single bit memory device within in time window between 10usec and 100msec using the previous embodiments is shown in figure (6). The shift (V) in threshold voltage Vt is given as a function of time (sec) for three different sets of drain Vd, program gate Vg and bulk Vb bias.

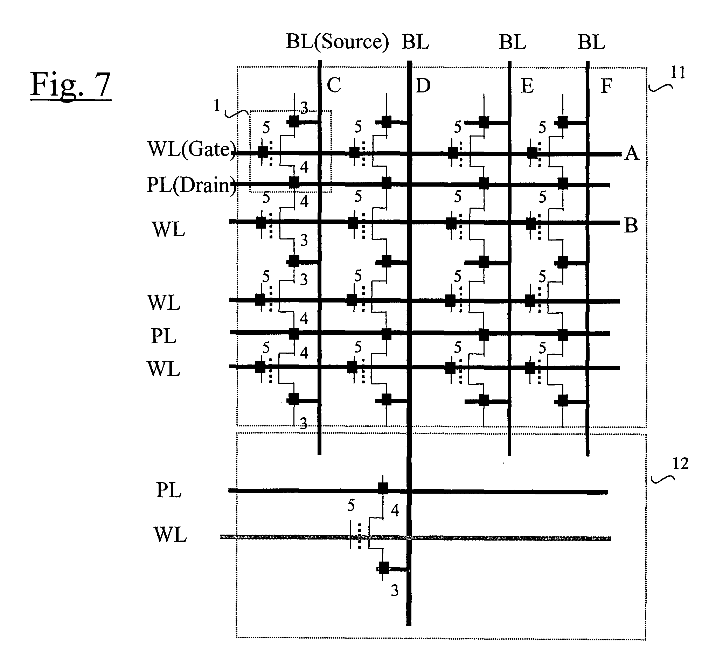

In a fourth aspect of the invention an efficient array configuration for the memory device according to the first aspect is disclosed. Figure 7 shows a memory comprising several sectors. Black squares indicate the connection between a metal line, e.g. wordline(WL), bitline (BL), program line (PL), and a terminal, e.g. source (3), drain (4) or gate electrode (5). In one sector the NOR-type memory array architecture according to one embodiment of the invention is shown. The memory cells are organized in columns. Two adjacent memory cells in each column have either the drain (4) or the source (3) node in common, e.g. it will have the source (3) in common with the memory cell (1) at one side and the drain node (4) in common with the memory cell at its opposite side. The drain (4) nodes of two adjacent memory cells in each column are connected, as indicated by the black squares in figure 7, to form a program line (PL), running perpendicular to the cell column. Preferably this program (PL) is formed in a first interconnect layer of metal connected via contacts or vias to the drain junction. As shown in figure 7 the memory devices are mirrored with respect to the program metal. The source nodes (3) of the memory cells in each column are connected to form a bit line, running parallel to the corresponding cell column. Preferably this bit line is formed in a second, higher, interconnect layer of metal connected via contacts or vias to the source junction. From each column the gate (5) of memory cells at identical horizontal positions in each column are connected by the word line (WL), running perpendicular to the cell column. Preferably this word line is formed in the polycrystalline silicon used to form the gate electrode (4) of each memory cell. So word lines and program lines are arranged in parallel. The memory array shown in figure 7 is a contacted array as the source (3), drain (4) and gate (5) terminal of the individual memory cell is contacted. At each intersection of a wordline (WL) and a bitline (BL) a memory cell (1) is located.

One advantage of the memory architecture according to this embodiment is that the highest voltage seen within one sector (11) at the drain (4) and the gate (5) of each cell can be limited, resulting in a high enough disturb margin.. Program inhibit is needed to prevent unwanted programming of memory cells. If for example the cell (1) at the intersection of column (C) and row (A) is to be programmed, the cells in row (A) belonging to the other columns (D, E, F) will be exposed to these drain and gate voltages. To prevent unwanted programming of these cells the respective other bitlines (BL: D, E, F) etc. will be biased, in this teaching, to a positive voltage. Because the bitlines (BL) are common between sector (11) above and sector (12) below, the memory cells of sector (12) will be exposed to a higher voltage at their sources (3) , which might cause disturbance within these cells. Thanks to the low program voltage, e.g. less than 4.5V in the examples given above, the inhibit voltage applied at the source side (3) of the memory cells in column (D) can be low. Because, as shown in figure 7, the bit line (BL) connecting the source nodes (3) of a column is common to all sectors, the bias applied to the this bit line will be seen by all memory cells in each sector sharing this bit line. A too high source inhibit voltage would introduce disturb across other sectors.

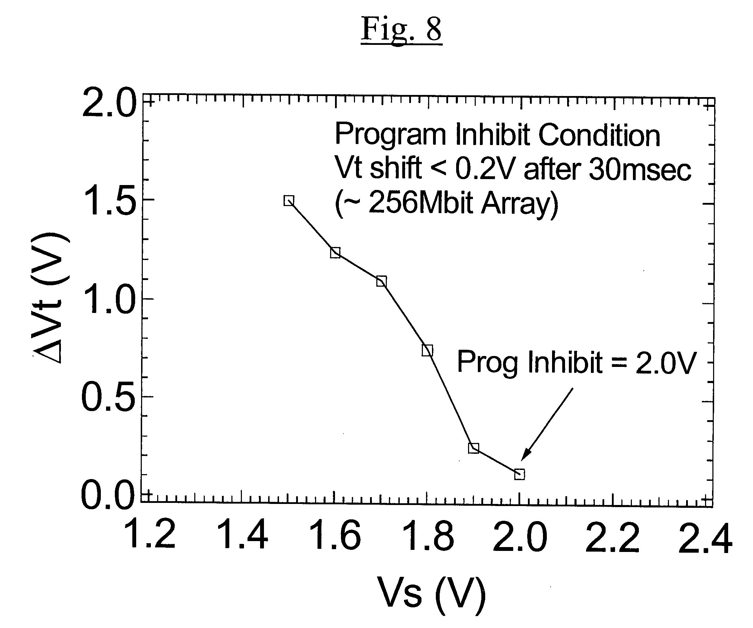

In a preferred embodiment, a source inhibit voltage Vs of 2V would be sufficient to prevent a significant shift (V) in threshold voltage Vt. As illustrated in figure 8 the threshold voltage shift decreases as function of the source voltage. A shift of less than 200mV can be obtained even the drain side is biased for 30 sec. For a 256 Mbit array, arranged in a 16K x 1K word configuration, the program time of memory array is about 20 milliseconds (msec): 1K word x 20usec/cell. The disturb time, i.e. the time during which cells of the mirror row are exposed to the program voltage of the adjacent row, would equal the program time of the memory array. The 30 seconds shown in figure 8 hence prove a large enough drain disturb margin.

## Claims

1. A method of programming a single bit nonvolatile memory cell integrated on a chip in a metal-dielectric-semiconductor technology,
said memory cell comprising
a semiconductor region (2) including a source region (3), a drain region (4), and a channel region (10) in-between said source region (3) and said drain region (4) ,
a control gate comprising a gate electrode (5) and dielectric stack (6), said gate electrode (5) being separated from said channel region (10) by said dielectric stack (6), said dielectric stack (6) comprising at least one charge storage dielectric layer (8),
said method comprising the steps of;
biasing said source region (3) to ground,
applying a first voltage, having a first polarity, to said drain region (4),
applying a second voltage, having the same polarity as said first voltage, to said gate electrode (5) ,
applying a third voltage, having the polarity opposite the polarity of said first and said second voltage, to said semiconductor region (2),
said first, said second and said third voltage cooperatively establishing programming of said cell (1) using injection of hot carriers generated by a secondary impact ionization mechanism into said at least one charge storage dielectric layer (8) at the drain (4) side of said memory cell (1).

2. A method as recited in claim 1 whereby the absolute value of said first, second and third voltage is 5V or less.

3. A method as recited in claim 1 or 2 whereby each difference between the absolute values of two voltages out said first, said second and said third voltage, is 1.5V or less.

4. A method as recited in claim 1 whereby the difference between the effective values of said second and said third voltage is at least 4V.

5. A method as recited in claim 4 whereby the absolute value of said second voltage and the absolute value of said third voltage is 5V or less.

6. A method as recited in any foregoing claim whereby said charge storage dielectric layer (8) is sandwiched between two oxide layers (7,9).

7. A method as recited any foregoing claim whereby said charge storage dielectric layer (8) comprises nitride.

8. A method of erasing a single bit nonvolatile memory cell integrated on a chip in a metal-dielectric-semiconductor technology,
said memory cell comprising
a semiconductor region (2) including a source region (3), a drain region (4), and a channel region (10) in-between said source region (3) and said drain region (4) ,
a control gate comprising a gate electrode (5) and a dielectric stack (6), said gate electrode (5) being separated from said channel region (10) by said dielectric stack (6), said dielectric stack (6) comprising at least one charge storage dielectric layer (8),
said method comprising the steps of;
biasing said source region (3) to ground,
applying a first voltage, having a first polarity, to said drain region (4),
applying a second voltage, having the polarity opposite the polarity of said first voltage, to said gate electrode (5),
applying a third voltage, having the same polarity as
said second voltage, to said semiconductor region (2), said first, said second and said third voltage cooperatively establishing erasing of said cell using substrate-enhanced-band-to-band-tunneling induced hot-carrier-injection into said at least one charge storage dielectric layer (8) at the drain (4) side of said memory cell (1).

9. A method as recited in claim 8 whereby the absolute value of said first, second and third voltage is 5V or less.

10. A method as recited in claim 9 whereby each difference between the absolute values of two voltages out said first, said second and said third voltage, is 1.5V or less.

11. A method of programming and/or reading in reverse direction a single bit nonvolatile memory cell integrated on a chip in a metal-dielectric-semiconductor technology,
said memory cell comprising
a semiconductor region (2) including a source region (3), a drain region (4), and a channel region (10) in-between said source region (3) and said drain region (4) ,
a control gate comprising a gate electrode (5) and a dielectric stack (6), said gate electrode (5) being separated from said channel region (10) by said dielectric stack (6), said dielectric stack (6) comprising at least one charge storage dielectric layer (8),
said method of programming comprising the steps of:
biasing said source region (3) to ground,
applying a first voltage, having a first polarity, to said drain region (4),
applying a second voltage, having the same polarity as said first voltage, to said gate electrode (5) ,
applying a third voltage, having the polarity opposite the polarity of said first and said second voltage, to
said semiconductor region (2),
said first, said second and said third voltage cooperatively establishing programming of said cell (1) using injection of hot carriers generated by a secondary impact ionization mechanism into said at least one charge storage dielectric layer (8) at the drain (4) side of said memory cell (1),
said method of reading said programmed memory cell in reverse direction comprising the steps of:
biasing said drain region (4) and said semiconductor region (2) to ground,
applying a first voltage, having a first polarity, to said source region (3),
applying a second voltage, having the same polarity as said first voltage, to said gate electrode (5) and,
subsequently sensing whether or not current is flowing from said drain region (4) towards said source region (3).

12. A memory circuit comprising
an array of single bit nonvolatile memory cells (1) , each of said memory cells (1) comprising a semiconductor region (2) including a source region (3), a drain region (4), and a channel region (10) in-between said source region (3) and said drain region (4), a control gate comprising a gate electrode (5) and a dielectric stack (6), said gate electrode (5) being separated from said channel region (10) by said dielectric stack (6), said dielectric stack (6) comprising at least one charge storage dielectric layer (8),
pheripheral circuitry,
**characterized in that**
said peripheral circuitry includes means for programming and/or erasing each of said single bit nonvolatile memory cells (1) using voltages having an absolute voltage of 5V or less.

13. A memory circuit as recited in claim 12 wherein said means for programming and/or erasing only includes circuitry capable of generating an on-chip voltage, having an absolute value of 5V or less.

14. A memory circuit, comprising an array of single bit nonvolatile memory cells (1) organized in columns,
each of said memory cells (1) comprises a semiconductor region (2) including a source region (3), a drain region (4), and a channel region (10) in-between said source region (3) and said drain region (4), a control gate comprising a gate electrode (5) and a dielectric stack (6), said gate electrode (5) being separated from said channel region (10) by said dielectric stack (6), said dielectric stack (6) comprising at least one charge storage dielectric layer (8),
**characterized in that**
in each column (C) adjacent memory cells have either the source region (3) or the drain region (4) in common, within each column (C) all source regions (3) are connected to the same bitline (BL) running parallel with this column (C),
within each column (C) each of said common drain regions (4) is connected to its respective wordline (WL) running perpendicular to said column (C), and;
within each column (C) each of said gate electrodes (5) is connected to its respective program line (PL) running perpendicular to said column (C).

15. A method for programming a memory cell (1) in a memory circuit as claimed in claim 14,
said method comprising the steps of
biasing the bitline (BL) connected to the source region (3) of said memory cell (1) to ground,
applying a first voltage, having a first polarity, to the wordline (WL) connected to the drain region (4) of said memory cell (1),
applying a second voltage, having the same polarity as said first voltage, to the program line (PL) connected to the gate electrode (5) of said memory cell (1),
applying a third voltage, having the polarity opposite the polarity of said first and said second voltage, to said semiconductor region (2), and
applying a fourth voltage, having the same polarity as said first voltage, to all other bitlines (BL) of said memory circuit.

16. A method as recited in claim 15 whereby
the absolute value of said first, second and third voltage is 5V or less and;
the absolute value of said fourth voltage is 2V or less.
